# EUROPEAN PATENT APPLICATION

(11) **EP 4 682 197 A1**
(43) Date of publication of application: **21.01.2026**
(21) Application number: 25163412.7
(22) Date of filing: 13.03.2025
(51) Int. Cl.: C08K 3/04, C08K 3/08, C08K 3/22, C08K 5/5313, C08K 5/3492, C08K 7/06, C08L 77/02, H05K 9/00

(54) **ELECTROMAGNETIC SHIELDING RESIN COMPOSITION AND AUTOMOBILE PARTS INCLUDING THE SAME**

(30) Priority: 18.07.2024 KR 20240094730
(71) Applicant: Hyundai Mobis Co., Ltd., Gangnam-gu Seoul 06141 (KR); Hanwha Compound Corporation, Yeosu-si Jeollanam-do 59616 (KR)
(72) Inventor: KANG, Hyoung Taek, 16891 Yongin-si, Gyeonggi-do (KR); KIM, Min Gyu, 16891 Yongin-si, Gyeonggi-do (KR); CHANG, Jae Joon, 16891 Yongin-si, Gyeonggi-do (KR); PARK, Byoung Chul, 34070 Yuseong-gu, Daejeon (KR); KIM, Min Jae, 30141 Sejong-si (KR); OH, Beom Jin, 34185 Yuseong-gu, Daejeon (KR)
(74) Representative: Sonnenhauser, Thomas Martin

(57) **Abstract**

The electromagnetic shielding resin composition includes: 5 to 40 parts by weight of a carbon-based filler, 10 to 30 parts by weight of a non-halogenated flame retardant, and 0.1 to 5 parts by weight of an anti-blooming agent based on 100 parts by weight of a polyamide resin.

## Description

### CROSS-REFERENCE TO RELATED APPLICATION

This application claims priority to and the benefit of Korean Patent Application No. 2024-0094730, filed on July 18, 2024, the disclosure of which is incorporated herein by reference in its entirety.

### BACKGROUND

### 1. Field of the Invention

The present invention relates to an electromagnetic shielding resin composition with improved performance in inhibiting flame retardant migration and an automotive part including the same.

### 2. Discussion of the Related Art

As the proportion of automotive electronic components is continuously increasing, and electrified components become more powerful and compact, the electromagnetic interference between automotive components is growing. As a result, there is a demand for the development of customized materials that meet the varying frequency ranges required for electromagnetic shielding performance in different electrified components and simultaneously provide both electromagnetic shielding performance and flame retardancy.

Examples of electrified components that need to exhibit both electromagnetic shielding performance and flame retardancy may include ducts in power conversion systems such as inverters or ICCs. An integrated charging control unit (ICCU) includes an on-board charger (OBC) and a low voltage DC-DC converter (LDC). The OBC is a device that converts AC commercial power to DC power to charge the high-voltage battery in electric vehicles (EVs) and plug-in hybrid vehicles (PHEVs), and the LDC is a device that converts high-voltage DC power to low-voltage DC power to charge low-voltage 12V batteries and supply power to the vehicle's electrical components.

In the case of polymer shielding materials, their design flexibility is superior to metal shielding plates, but physical properties such as shielding performance, flame retardancy, brittleness, or fluidity need to be improved. For conventional polymer shielding materials, electromagnetic shielding performance was controlled by varying the types and compositions of fillers and flame retardants. However, the use of halogenated flame retardants has been excluded due to environmental issues, so it is necessary to develop new compositions. Non-halogenated flame retardants include phosphorus-based and nitrogen-based flame retardants.

For phosphorus-based flame retardants that can be used in polyamide resins, migration to the surface can occur in high-temperature and high-humidity conditions, and the migrated flame retardants can affect surface electrical conductivity, leading to a decrease in electromagnetic shielding performance.

To apply electromagnetic shielding compositions to automotive parts, flame retardancy needs to be secured, and electromagnetic shielding properties need to be maintained stably even under high-temperature and high-humidity conditions by inhibiting flame retardant migration. Therefore, there is a demand for the development of electromagnetic shielding compositions with improved performance in inhibiting flame retardant migration.

### SUMMARY

Embodiments disclosed herein are directed to an electromagnetic shielding resin composition with excellent electromagnetic shielding performance and improved environmental reliability by inhibiting flame retardant migration and minimizing changes in electromagnetic shielding properties, and an automotive part manufactured using the same.

In a general aspect of the present disclosure, the electromagnetic shielding resin composition includes: 5 to 40 parts by weight of a carbon-based filler, 10 to 30 parts by weight of a non-halogenated flame retardant, and 0.1 to 5 parts by weight of an anti-blooming agent based on 100 parts by weight of a polyamide resin.

The polyamide resin may have a melting temperature of 150 to 350 °C.

The polyamide resin may have a relative viscosity (RV) of 1.5 to 5.0.

The polyamide resin may have a number average molecular weight of 8,000 to 100,000 g/mol.

The polyamide resin may be one or more selected from the group consisting of polyamide-6, polyamide-11, polyamide-12, polyamide-4,6, polyamide-4,8, polyamide-4,10, polyamide-4,12, polyamide-6,6, polyamide-6,9, polyamide-6,10, polyamide-6,12, polyamide-10,10, polyamide-12,12, and copolymers thereof.

The carbon based filler may be one or more selected from the group consisting of carbon fiber, carbon nanotubes, and carbon black.

The diameter of the carbon fiber may be 4 µm to 10 µm and the length of the carbon fiber may be 1 mm to 10 mm, respectively.

The carbon fiber may be a metal-coated carbon fiber and the metal may be selected from the group consisting of copper, silver, gold, palladium, nickel, aluminum, and magnesium.

The carbon nanotubes may be selected from the group consisting of single-walled carbon nanotubes, double-walled carbon nanotubes, multi-walled carbon nanotubes, and bundled carbon nanotubes.

The average particle size of the carbon nanotubes may range from 1 nm to 50 nm.

The non-halogenated flame retardant may be one or more selected from the group consisting of a phosphorus-based flame retardant and a nitrogen-based flame retardant.

The phosphorus-based flame retardants may be selected from the group consisting of phosphate compounds, phosphonate compounds, phosphinate compounds, phosphine oxide compounds, phosphazene compounds, and metal salts thereof.

The nitrogen-based flame retardants may be selected from the group consisting of melamine, melamine phosphate, melamine polyphosphate, and melamine cyanurate.

The anti-blooming agent may be molybdenum powder.

The average particle size of the molybdenum powder may range from 0.1 to 1 µm.

The electromagnetic shielding resin composition may further include one or more additives selected from the group consisting of antioxidants, lubricants, compatibilizers, release agents, flame retardant synergists, colorants, antistatic agents, plasticizers, heat stabilizers, light stabilizers, anti-dripping agents, and pigments.

In another general aspect of the present disclosure, the automotive part may be manufactured by molding the electromagnetic shielding resin composition.

The automotive part may have an electromagnetic shielding performance of 30 dB or more when measured using the ASTM ES 7 test method at frequency bands of 100 MHz and 1 GHz.

The automotive part may have an electromagnetic shielding performance of 40 dB or more when measured using the ASTM ES 7 test method at frequency bands of 100 MHz and 1 GHz.

The automotive part may achieve a V-0 grade flame retardancy rating when measured based on 1.5T according to the UL94 vertical flame retardancy test method.

### DETAILED DESCRIPTION

Hereinafter, the present invention will be described in detail with reference to embodiments and drawings. However, the following embodiments are provided as examples to help understanding of the present invention, and the scope of the present invention is not limited thereto. The present invention may be subject to various modifications and may be implemented in different forms, and it should be understood that all modifications, equivalents, and substitutes within the spirit and technical scope of the present invention are included.

The terms used in this application are used only to describe specific embodiments and are not intended to limit the present invention. Singular expressions include plural expressions unless the context clearly indicates otherwise. In this application, terms such as "include" and "have" are intended to indicate the presence of features, numbers, steps, operations, components, parts, or combinations thereof described in the specification, and do not preclude the possibility of the presence or addition of one or more other features, numbers, steps, operations, components, parts, or combinations thereof.

Unless otherwise defined, all terms, including technical and scientific terms, used herein have the same meaning as commonly understood by a person of ordinary skill in the art to which the present invention pertains. It will be further understood that terms such as those defined in commonly used dictionaries should be interpreted as having a meaning that is consistent with their meaning in the context of the relevant art and will not be interpreted in an idealistic or overly formal sense unless explicitly defined herein.

The electromagnetic shielding resin composition according to the present embodiment may include a polyamide resin, a carbon-based filler, a non-halogenated flame retardant, and an anti-blooming agent. Hereinafter, each component and content of the electromagnetic shielding resin composition will be described.

### <Polyamide resin>

As the base resin for the electromagnetic shielding resin composition according to the present embodiment, polyamide, which is a heat-resistant polymer, may be used, but the base resin is not limited thereto, and any heat-resistant polymer may be used without limitation.

For example, the polyamide resin may be one or more selected from the group consisting of polyamide-6, polyamide-11, polyamide-12, polyamide-4,6, polyamide-4,8, polyamide-4,10, polyamide-4,12, polyamide-6,6, polyamide-6,9, polyamide-6,10, polyamide-6,12, polyamide-10,10, polyamide-12,12, and copolymers thereof.

Among them, nylon 6 is more preferably for use in electromagnetic shielding resin compositions because of its excellent heat resistance, chemical resistance, and mechanical properties.

The polyamide resin may have a melting temperature of, for example, 150 to 350 °C, 200 to 300 °C, or 220 to 280 °C. Within this range, the polyamide resin exhibits excellent heat resistance.

The polyamide resin may have a relative viscosity (RV) of, for example, 1.5 to 5.0, 2 to 4, or 2.0 to 3.5, preferably 2.1 to 2.5. Within this range, the polyamide resin has excellent moldability and processability.

The polyamide resin may have a number average molecular weight of, for example, 8,000 to 100,000 g/mol, 10,000 to 700,000 g/mol, 10,000 to 500,000 g/mol, or 10,000 to 50,000 g/mol. Within this range, molded articles have excellent appearance characteristics and mechanical strength.

### <Carbon-based filler>

The electromagnetic shielding resin composition according to the present embodiment may include one or more carbon-based fillers selected from carbon fiber, carbon nanotubes, and carbon black.

Carbon-based fillers are important materials that may improve the mechanical, electrical, and thermal properties of polymer composites and enhance the overall performance of products. They may improve mechanical properties, such as strength, hardness, and wear resistance, of polymer resin compositions, impart electrical conductivity to insulating materials such as plastics, and help maintain performance at high temperatures by enhancing thermal conductivity. In addition, fillers such as carbon fiber provide a high strength-to-weight ratio, making them advantageous for applications requiring weight reduction.

To achieve optimal performance, it is necessary to determine the input amount according to the properties of other materials, and to adjust processing conditions such as temperature, pressure, and time.

Carbon black is composed of fine carbon particles and has a high surface area and excellent conductivity. Adding carbon black to the resin composition may improve mechanical strength and electrical conductivity, provide UV protection, and ensure process stability during the manufacturing of the resin composition.

Carbon fiber is suitable as a filler because it has a high specific surface area and excellent electrical conductivity, adsorption, and mechanical properties. The diameter of the carbon fiber may be 4 µm to 10 µm, specifically 5 µm to 8 µm, but is not limited thereto. The length of the carbon fiber may be 1 mm to 10 mm, specifically 3 mm to 8 mm, but is not limited thereto. When the diameter and length of carbon fiber are within the above ranges, it is easy to form a network structure and achieve excellent processability.

Metal-coated carbon fibers may also be used. The metal applied to the metal-coated carbon fibers may be any one selected from copper, silver, gold, palladium, nickel, aluminum, and magnesium, or a combination of two or more thereof, preferably nickel, aluminum, and palladium, but is not limited thereto. Metal-coated carbon fibers have higher conductivity and durability compared to existing carbon fibers, thereby demonstrating superior electromagnetic shielding efficiency.

Carbon nanotubes (CNTs) are carbon structures with nanometer-scale diameters and micrometer-scale lengths, and exhibit excellent mechanical strength, electrical conductivity, and thermal conductivity. Various types of carbon nanotubes may be used, including single-walled carbon nanotubes, double-walled carbon nanotubes, multi-walled carbon nanotubes, and bundled carbon nanotubes, but are not limited thereto.

The average particle size of carbon nanotubes may range from 1 nm to 50 nm, preferably 10 nm to 20 nm, but is not limited thereto. When carbon nanotubes with a particle size within the above range are used, it is possible to further improve the electrical conductivity, electromagnetic shielding performance, and processability of the resin composite.

In the electromagnetic shielding resin composition according to an embodiment of the present invention, the content of the carbon-based filler may be 5 to 40 parts by weight based on 100 parts by weight of the polyamide resin. In addition, the carbon-based filler may be one or more selected from carbon fiber, carbon nanotubes, and carbon black, and using a mixture of two or more thereof is more advantageous in improving mechanical strength, conductivity, and electromagnetic shielding efficiency. In this case, the content of each of the carbon fiber, carbon nanotubes, and carbon black may be 1 to 30 parts by weight, preferably 5 to 20 parts by weight, based on 100 parts by weight of the polyamide resin.

### <Flame retardant>

The electromagnetic shielding resin composition according to the present embodiment may include a phosphorus-based flame retardant, a nitrogen-based flame retardant, or a mixture thereof as a non-halogenated flame retardant. The present invention excludes the use of halogenated flame retardants, which are environmentally harmful, and instead uses environmentally friendly non-halogenated flame retardants. Examples of non-halogenated flame retardants may include phosphorus-based flame retardants and nitrogen-based flame retardants.

Phosphorus-based flame retardants may include phosphate compounds, phosphonate compounds, phosphinate compounds, phosphine oxide compounds, phosphazene compounds, metal salts thereof, and the like. These may be used alone or as a mixture of two or more types.

Specific examples of phosphorus-based flame retardants may include aluminum diethyl phosphate, diphenyl phosphate, diaryl phosphate, triphenyl phosphate, tricresyl phosphate, trixylyl phosphate, tri(2,6-dimethylphenyl) phosphate, tri(2,4,6-trimethylphenyl) phosphate, tri(2,4-di-tert-butylphenyl) phosphate, tri(2,6-dimethylphenyl) phosphate, bisphenol-A bis(diphenyl phosphate), resorcinol bis(diphenyl phosphate), resorcinol bis[bis(2,6-dimethylphenyl) phosphate], resorcinol bis[bis(2,4-di-tert-butylphenyl) phosphate], hydroquinone bis[bis(2,6-dimethylphenyl) phosphate], hydroquinone bis[bis(2,4-di-tert-butylphenyl) phosphate], oligomeric phosphate ester compounds, etc., but are not limited thereto. The phosphorus-based flame retardants may be used alone or as a mixture of two or more types.

Nitrogen-based flame retardants may include melamine and melamine derivatives.

Specific examples of nitrogen-based flame retardants may include melamine, melamine phosphate, melamine polyphosphate, melamine cyanurate, etc., but are not limited thereto. Nitrogen-based flame retardants may be used alone or as a mixture of two or more types.

In the electromagnetic shielding resin composition according to an embodiment of the present invention, the content of the flame retardant may be 10 to 30 parts by weight, preferably 15 to 20 parts by weight, based on 100 parts by weight of the polyamide resin.

The phosphorus-based flame retardant and/or nitrogen-based flame retardant may be used alone or as a mixture of two or more types in a content at the above ratio. It is preferable to use the flame retardant within the above content range because it has excellent flame retardancy and mechanical properties such as tensile strength and impact strength within the range. When the total content of the flame retardant is less than 10 parts by weight based on 100 parts by weight of the polyamide resin, flame retardancy may be insufficient. When the total content exceeds 30 parts by weight, physical properties such as adhesion or processability during the application of a resin layer may deteriorate.

### <Anti-blooming agent>

The electromagnetic shielding resin composition according to the present embodiment includes an anti-blooming agent along with a non-halogenated flame retardant. The anti-blooming agent is a type of additive used in various industries to prevent blooming, which is the formation of unwanted films or residues on surfaces. Anti-blooming agents interact with other additives or substrate materials to form a barrier that inhibits their migration to the surface or prevents other substances from moving to the surface.

Phosphorus-based flame retardants that can be used in polyamide resins may migrate to the surface under high-temperature and high-humidity conditions, and the migrated flame retardants may affect surface electrical conductivity, leading to a decrease in electromagnetic shielding performance.

To apply electromagnetic shielding compositions to automotive parts, flame retardancy needs to be secured, and electromagnetic shielding properties need to be maintained stably even under high-temperature and high-humidity conditions by inhibiting flame retardant migration. To this end, an anti-blooming agent was added to the electromagnetic shielding resin composition to inhibit flame retardant migration, thereby maintaining electromagnetic shielding performance.

According to an embodiment of the present invention, molybdenum-based anti-blooming agents, sodium-based anti-blooming agents, or a mixture thereof may be used.

Molybdenum-based anti-blooming agents may include alloys or compounds containing molybdenum, molybdenum disulfide (MoS2), and molybdenum dithiocarbamate (MoDTC), etc., and are used in a powder or solution form. For the molybdenum powder, it is suitable to use molybdenum with an average particle size of 0.1 to 1.9 µm, preferably 0.5 to 0.9 µm, to achieve miscibility with other materials and the effect of inhibiting migration. Molybdenum provides excellent wear prevention and friction reduction properties, which may contribute to extending the lifetime and improving the performance of mechanical components.

Sodium-based anti-blooming agents may include sodium antimonate and used in a powder or solution form. A sodium-based anti-blooming agent powder having a size ranging from 3 to 8 µm may be used.

In the electromagnetic shielding resin composition according to an embodiment of the present invention, the content of the anti-blooming agent may be 0.1 to 5 parts by weight, preferably 0.5 to 1 part by weight, based on 100 parts by weight of the polyamide resin.

When the content of the anti-blooming agent is less than 0.1 parts by weight based on 100 parts by weight of the polyamide resin, it is difficult to achieve the effect of inhibiting migration, and when the content exceeds 5 parts by weight, other properties or processability may deteriorate. Therefore, it is preferably to use it within the above range.

### <Other additives>

As needed, the electromagnetic shielding resin composition according to an embodiment of the present invention may optionally further include one or more additives selected from antioxidants, lubricants, compatibilizers, release agents, flame retardant synergists, colorants, antistatic agents, plasticizers, heat stabilizers, light stabilizers, anti-dripping agents, and pigments.

Among them, an antioxidant may be selected to prevent deterioration due to oxidation when the electromagnetic shielding resin composition is kneaded at high temperatures. The antioxidant may include one or more selected from phenolic compounds and thioether compounds, but is not limited thereto, and any antioxidant commonly used in polyamide-based resin compositions may be selected and used.

Specific examples of phenolic antioxidants may include 2,2'-thiodiethylene-bis-(3,5-di-t-butyl-4-hydroxyphenyl)propionate, 4,4'-thio-bis-(2-t-butyl-5-methylphenol), 1,2-dihydro-2,2,4-trimethylquinoline, diethyl((3,5-bis-(1,1-dimethylethyl)-4-hydroxyphenyl)methyl)phosphonate, 1,3,4-tris(4-tert-butyl-3-hydroxy-2,6-dimethylbenzene)-1,3,5-triazine-2,4,6-(1H,3H,5H)-trione, tetrakis[methylene-3-(3,5-di-tert-butyl-4-hydroxyphenyl)propionate]methane, octadecyl-3-(3,5-di-tert-butyl-4-hydroxyphenyl)propionate, tris(2,4-di-tert-butylphenyl)phosphite, N,N'-bis-(3-(3',5'-di-t-butyl-4'-hydroxyphenyl)propionyl)hydrazine, etc., and one or more thereof may be selected and used, but the phenolic antioxidants are not limited thereto.

Thioether compounds may include dilauryl thiodipropionate, ditridecyl thiodipropionate, dimyristyl thiodipropionate, dioctadecyl disulfide, bis[2-methyl-4-(3-n-dodecylthiopropionyloxy)-5-tert-butylphenyl] sulfide, pentaerythritol-tetrakis-(3-laurylthiopropionate), 1,4-cyclohexane dimethanol, 3,3'-thiobispropionic acid dimethyl ester polymer, distearyl thiodipropionate, etc., and one or more thereof may be selected and used, but the thioether compounds are not limited thereto.

By using the antioxidant, it is possible to prevent the degradation of the polyamide resin caused by radicals generated during the processing of polyamide resin, and if necessary, a mixture of phenolic compounds and thioether compounds may also be used to enhance the antioxidant effect.

In addition to the antioxidant, one or more additives selected from lubricants, compatibilizers, release agents, flame retardant synergists, colorants, antistatic agents, plasticizers, heat stabilizers, light stabilizers, anti-dripping agents, and pigments, which are commonly used in polyamide-based resin compositions, may be further included.

The electromagnetic shielding resin composition according to an embodiment of the present invention includes a polyamide resin, a carbon-based filler, a non-halogenated flame retardant, and an anti-blooming agent, and based on 100 parts by weight of the polyamide resin, 10 to 30 parts by weight of the carbon-based filler, 10 to 30 parts by weight of the non-halogenated flame retardant, and 0.1 to 5 parts by weight of the anti-blooming agent may be included.

When the contents of the polyamide resin, carbon-based filler, non-halogenated flame retardant, and anti-blooming agent in the electromagnetic shielding resin composition are within the above numerical ranges, sufficient flame retardancy and electromagnetic shielding performance may be exhibited, and there are advantages in terms of the balance of physical properties, including mechanical properties, extrusion processability, and appearance quality.

Hereinafter, the present invention will be described in more detail through the following examples and test examples. However, these are presented for illustrative purposes to help understand the present invention and should not be construed as limiting the scope of the invention.

### <Examples>

Electromagnetic shielding resin compositions of Examples 1 and 2 were prepared according to the composition shown in Table 1 below. The specific materials used in the preparation of the compositions are as follows.
- PA6: 1027BRT from HYOSUNG CHEMICAL was used.
- Carbon fiber: TR50S from Mitsubishi Rayon, which is an epoxy-sized chopped carbon fiber with a length of 6 mm, was used.
- Multi-walled carbon nanotubes (MWCNTs): KRU4357 (10-20 nm) from Korea Nanomaterials was used.
- Carbon black: Chezacarb AC-80 (Nitrogen surface area: min 800) from Orlen Unipetrol was used.
- Phosphorus-based flame retardant: composed of aluminum diethyl phosphate, and AP1050A (phosphorus content: 23.3-24.0) from FRPUER was used.
- Nitrogen-based flame retardant (1): composed of melamine cyanorate, and MCA from Green Mountain Chemical Co., Ltd. was used.
- Nitrogen-based flame retardant (2): composed of melamine polyphosphate, and MELAPRU 200 (nitrogen content: 42-44%) from ATAMAN Chemicals was used.
- Anti-blooming agent
   a) Molybdenum-based: Mo-H (particle size: 0.5-0.9 um) from Japan New Metals Co., Ltd. was used as a high-purity molybdenum powder.
   b) Sodium-based: SA-200 (particle size: 3-8 um) from Nihon Seiko Co., Ltd. was used as high-purity sodium antimonate.
- Antioxidant: IRGANOX1010 from Ciba Specialty Chemicals was used.
- Lubricant: Hi-Lube from Shinwon Chemical Co., Ltd. was used.

**[Table 1]**

| Components | Example 1 | Example 2 | |
|---|---|---|---|
| PA6 | 100 | 100 | |
| Carbon fiber (6 mm) | 20 | 20 | |
| MWCNT | | 5 | 5 |
| Carbon black | | 10 | 10 |
| Phosphorus-based flame retardant | | 20 | 10 |
| Nitrogen-based flame retardant (1) | | - | 10 |
| Nitrogen-based flame retardant (2) | | - | - |
| Anti-blooming agent | Molybdenum-based | 1.0 | 1.0 |
| | Sodium-based | - | - |
| Antioxidant | | 0.5 | 0.5 |
| Lubricant | | 0.3 | 0.3 |

### <Comparative Examples>

Electromagnetic shielding resin compositions of Comparative Examples 1 to 14 were prepared according to the compositions shown in Tables 2 and 3 below. The specific materials used in the preparation of the compositions are the same as in the above Examples.

**[Table 2]**

| Components | | Compa rative Exampl e 1 | Compa rative Exampl e 2 | Compa rative Exampl e 3 | Compa rative Exampl e 4 | Compa rative Exampl e 5 | Compa rative Exampl e 6 | Compa rative Exampl e 7 |
|---|---|---|---|---|---|---|---|---|
| PA6 | | 100 | 100 | 100 | 100 | 100 | 100 | 100 |
| Carbon fiber (6 mm) | | 20 | 20 | 20 | 20 | 20 | 20 | 20 |
| MWCNT | | 5 | 5 | 5 | 5 | 5 | 5 | 5 |
| Carbon black | | 10 | 10 | 10 | 10 | 10 | 10 | 10 |
| Phosphorus-based flame retardant | | 20 | 20 | 20 | 10 | 10 | 10 | - |
| Nitrogen-based flame retardant (1) | | - | - | - | 10 | 10 | 10 | 20 |
| Nitrogen-based flame retardant (2) | | - | - | - | - | - | - | - |
| Anti-blooming agent | Molybden um-based | - | 0.5 | 1.5 | - | 0.5 | 1.5 | - |
| | Sodium-based | - | - | - | - | - | - | 1.0 |
| Antioxidant | 0.5 | 0.5 | 0.5 | 0.5 | 0.5 | 0.5 | 0.5 | |
| Lubricant | 0.3 | 0.3 | 0.3 | 0.3 | 0.3 | 0.3 | 0.3 | |

**[Table 3]**

| Components | | Compar ative Exampl e 8 | Compar ative Exampl e 9 | Compar ative Exampl e 10 | Compar ative Exampl e 11 | Compar ative Exampl e 12 | Compar ative Exampl e 13 | Compar ative Exampl e 14 |
|---|---|---|---|---|---|---|---|---|
| PA6 | | 100 | 100 | 100 | 100 | 100 | 100 | 100 |
| Carbon fiber (6 mm) | | 20 | 20 | 20 | 20 | 20 | 20 | 20 |
| MWCNT | | 5 | 5 | 5 | 5 | 5 | 5 | 5 |
| Carbon black | | 10 | 10 | 10 | 10 | 10 | 10 | 10 |
| Phosphorus-based flame retardant | | 5 | 15 | 20 | 10 | 10 | - | - |
| Nitrogen-based flame retardant (1) | | 15 | 5 | - | - | - | - | - |
| Nitrogen-based flame retardant (2) | | - | - | - | 15 | 10 | 20 | 30 |
| Anti-blooming agent | Molybd enum-based | - | - | | - | - | - | 1.0 |
| | Sodium -based | 1.0 | 1.0 | | 1.0 | 1.0 | 1.0 | - |
| Antioxidant | | 0.5 | 0.5 | 0.5 | 0.5 | 0.5 | 0.5 | 0.5 |
| Lubricant | | 0.3 | 0.3 | 0.3 | 0.3 | 0.3 | 0.3 | 0.3 |

### <Test Examples>

The physical properties of molded articles of the resin compositions prepared according to Examples and Comparative Examples were measured as follows, and results are shown in Table 4.

### 1) Electromagnetic shielding performance test

Samples were prepared, and the shielding rate of the flat samples was measured according to the ASTM ES7 test method. The measurable frequency band was 3 GHz, and the frequency bands for evaluation were 100 MHz and 1 GHz. To verify the stability of electromagnetic shielding efficiency, high-temperature and high-humidity tests were conducted under conditions of 85 °C/85% RH for 7 days.

### 2) Anti-blooming test

The degree of blooming in the resin composition was visually observed and rated as good (⊚), average (∘), or poor (X) based on whether flame retardant migration occurred in high-temperature and high-humidity conditions of 85 °C/85% RH for 1,000 hours. When flame retardant migration occurs under high-temperature and high-humidity conditions, whitening appears on the surface.

In addition, the flame retardant migration in the resin composition was observed even under more severe conditions of 120 °C and 85 °C for 96 hours.

### 3) Flame retardancy test

Flame retardancy was measured for 1.5 mm (1.5T) thick samples according to the UL 94 vertical flame retardancy test method.

### 4) Impact strength test

The impact strength was measured at room temperature on 4T thick samples according to the ISO 180 test method.

**[Table 4]**

| Items | | Example 1 | Example 2 |
|---|---|---|---|
| Anti-blooming property | | ⊚ | ⊚ |
| Impact strength (KJ/m²) | | 7.1 | 7.4 |
| Electromagnetic shielding efficiency | Before test | 42.4 | 42.8 |
| | After test | 42.2 | 42.5 |
| Flame retardancy | | V-0 | V-0 |

**[Table 5]**

| Items | | Compar ative Exampl e 1 | Compar ative Exampl e 2 | Compar ative Exampl e 3 | Compar ative Exampl e 4 | Compar ative Exampl e 5 | Compar ative Exampl e 6 | Compar ative Exampl e 7 |
|---|---|---|---|---|---|---|---|---|
| Anti-blooming property | | X | X | ⊚ | X | X | ⊚ | X |
| Impact strength (KJ/m²) | | 6.9 | 6.7 | 6.0 | 6.8 | 6.5 | 5.9 | 6.5 |
| Electrom agnetic shielding efficienc y | Befor e test | 41.9 | 42.4 | 42.4 | 42.2 | 41.4 | 41.4 | 42.4 |
| | After test | 35.2 | 34.5 | 41.2 | 33.5 | 34.7 | 40.6 | 34.5 |
| Flame retardancy | V-1 | V-0 | V-0 | V-1 | V-0 | V-0 | V-1 | |

**[Table 6]**

| Items | | Compar ative Exampl e 8 | Compar ative Exampl e 9 | Compar ative Exampl e 10 | Compar ative Exampl e 11 | Compar ative Exampl e 12 | Compar ative Exampl e 13 | Compar ative Exampl e 14 |
|---|---|---|---|---|---|---|---|---|
| Anti-blooming property | | X | X | X | X | X | X | ⊚ |
| Impact strength (KJ/m²) | | 6.3 | 6.1 | 6.5 | 6.3 | 6.7 | 6.5 | 6.4 |
| Electrom agnetic shielding efficienc y | Befor e test | 42.7 | 42.6 | 42.4 | 42.0 | 42.5 | 42.3 | 42.8 |
| | After test | 32.3 | 34.4 | 36.2 | 33.9 | 35.1 | 31.2 | 42.5 |
| Flame retardancy | | V-0 | V-0 | V-1 | V-0 | V-1 | V-1 | V-2 |

As shown in Table 1, molded articles using the resin composition of Examples including a molybdenum-based anti-blooming agent inhibited the migration of flame retardants and thus had good anti-blooming evaluation results, and even after high-temperature and high-humidity tests, a high electromagnetic shielding effect of 40 dB or more was exhibited.

In addition, molded articles using the resin composition of Examples showed excellent impact strength and outstanding flame retardancy results with a V-0 grade, confirming their suitability for use in automotive parts.

The resin composition according to the present invention and the automotive part molded using the same have excellent flame retardancy and electromagnetic shielding properties. Phosphorus-based flame retardants which are added to ensure flame retardancy may migrate to the surface in high-temperature and high-humidity conditions, and the migrated flame retardants may affect surface electrical conductivity, leading to a decrease in electromagnetic shielding performance.

The resin composition according to the present invention can achieve stable electromagnetic shielding properties of the components by inhibiting the migration of flame retardants and minimizing changes in shielding properties under environmental reliability evaluation conditions.

The resin composition according to the present invention can exhibit V-0 grade flame retardancy at 1.5T according to the UL94 test method and electromagnetic shielding properties of 30 dB or more, or 40 dB or more, at 1 GHz. In addition, the resin composition can stably maintain its electromagnetic shielding properties even under high-temperature and high-humidity conditions by inhibiting flame retardant migration, making it suitable for application in automotive parts.

The present invention has been described with reference to preferred embodiments, but those skilled in the art will understand that various modifications and changes can be made to the invention without departing from the spirit and scope of the present invention as defined in the following claims.

## Claims

1. An electromagnetic shielding resin composition comprising:
5 to 40 parts by weight of a carbon-based filler, 10 to 30 parts by weight of a non-halogenated flame retardant, and 0.1 to 5 parts by weight of an anti-blooming agent, based on 100 parts by weight of a polyamide resin.

2. The electromagnetic shielding resin composition of claim 1, wherein the polyamide resin is one or more selected from the group consisting of polyamide-6, polyamide-11, polyamide-12, polyamide-4,6, polyamide-4,8, polyamide-4,10, polyamide-4,12, polyamide-6,6, polyamide-6,9, polyamide-6,10, polyamide-6,12, polyamide-10,10, polyamide-12,12, and copolymers thereof.

3. The electromagnetic shielding resin composition of claim 1 or 2, wherein the carbon-based filler is one or more selected from the group consisting of carbon fiber, carbon nanotubes, and carbon black.

4. The electromagnetic shielding resin composition of any one of claims 1 to 3, wherein the non-halogenated flame retardant is one or more selected from the group consisting of a phosphorus-based flame retardant and a nitrogen-based flame retardant.

5. The electromagnetic shielding resin composition of any one of claims 1 to 4, wherein the anti-blooming agent is molybdenum powder.

6. The electromagnetic shielding resin composition of claim 5, wherein an average particle size of the molybdenum powder ranges from 0.1 to 1 µm.

7. The electromagnetic shielding resin composition of any one of claims 1 to 6, further comprising one or more additives selected from the group consisting of antioxidants, lubricants, compatibilizers, release agents, flame retardant synergists, colorants, antistatic agents, plasticizers, heat stabilizers, light stabilizers, anti-dripping agents, and pigments.

8. An automotive part manufactured by molding the electromagnetic shielding resin composition of any one of claims 1 to 7.

9. The automotive part of claim 8, wherein an electromagnetic shielding performance measured under ASTM ES 7 test conditions at frequency bands of 100 MHz and 1 GHz is 30 dB or more.

10. The automotive part of claim 8 or 9, wherein a flame retardancy measured based on 1.5T according to UL94 vertical flame retardancy test method is a V-0 grade.
